# EUROPEAN PATENT SPECIFICATION

(11) **EP 1 679 944 B1**
(45) Date of publication and mention of the grant of the patent: **14.05.2008**
(21) Application number: 05000345.8
(22) Date of filing: 10.01.2005
(51) Int. Cl.: H05K 5/02, H05K 7/14

(54) **Functional module in the field of telecommunications and a combination of at least one telecommunications module and at least one functional module as well as a method of installing and/or handling a functional module**
Eine Kombination aus wenigstens einem Telekommunikationsmodul und wenigstens einem Funktionsmodul und eine Methode der Installation und Behandlung des Funktionsmoduls
Une combinaison d'au moins un module de télécommunication et au moins un module fonctionnel ainsi qu'un procédé d'installation et de traitement de ce module fonctionnel

(43) Date of publication of application: 12.07.2006
(73) Proprietor: 3M Innovative Properties Company, St. Paul, Minnesota 55133-3427 (US)
(72) Inventor: Koruschowitz, Axel, 42781 Haan (DE); Bund, Christine, Dipl.-Ing., 41453 Neuss (DE); Bauer, Manfred, Dr., 42119 Wuppertal (DE); Denter, Friedrich, Dipl.-Ing., 44575 Castrop-Rauxel (DE)
(74) Representative: Bergen, Katja

(56) References cited:
- US-A- 5 539 818
- US-A- 5 734 558
- US-A1- 2002 082 042
- US-B1- 6 449 171
- PATENT ABSTRACTS OF JAPAN vol. 1999, no. 08, 30 June 1999 (1999-06-30) & JP 11 087950 A (FUJITSU DENSO LTD), 30 March 1999 (1999-03-30)

## Description

### Technical Field

The invention relates to a functional module in the field of telecommunications and a combination of at least one telecommunications module and at least one functional module as well as a method of installing and/or handling a functional module.

### Background

In the field of telecommunications, numerous customers are connected with the switch of a telecommunications company via telecommunications lines. The customers can also be called subscribers. The switch is also called an exchange or PBX (central office exchange operated by the telecommunications company). Between the subscriber and the switch, sections of the telecommunications lines are connected with telecommunications modules. The telecommunications modules establish an electrical connection between a wire which is attached to the telecommunications module at a first side, and another wire which is attached to the telecommunications module at a second side. The wires of one side can also be called incoming wires and the wires of the other side can be called outgoing wires. Plural telecommunications modules can be put together at a distribution point, such as a main distribution frame, an intermediate distribution frame, an outside cabinet or a distribution point located, for example, in an office building or on a particular floor of an office building. To allow flexible wiring, some telecommunications lines are connected with first telecommunications modules in a manner to constitute a permanent connection. Flexibility is realized by so-called jumpers or cross connects, which flexibly connect contacts of the first telecommunications module with contacts of a second telecommunications module. These jumpers can be changed when a person moves within an office building to provide a different telephone (i.e. a different telephone line) with a certain telephone number, which the relocated person intends to keep. In the telecommunications module, disconnection points can be located in the electrical connection between the two sides. At such disconnection points, disconnection plugs can be inserted, in order to disconnect the line. Furthermore, protection plugs and magazines are known. These are connected to the module and protect any equipment connected to the wires from overcurrent and overvoltage. Finally, test plugs can be inserted at a disconnection point in order to test or monitor a line.

Recently, ADSL-technology has spread widely in the field of telecommunications. This technology allows at least two different signals to be transmitted on a single line. This is achieved by transmitting the different signals at different frequencies along the same line. The signals are combined at a particular point in the telecommunications line and split at another point. In particular, at the subscriber side, voice and data signals, which are separate, are combined and sent to the central office via the same line. In the central office the combined signal is split. For the transmission of voice and data signals to the subscriber, separate voice and data signals are combined at the central office, sent to the subscriber and split at the subscriber side. After splitting the signal, the so-called POTS-signal (plain old telephone service) can be used to transmit voice signals. The remaining part of the split signal can be used to transmit data, for example. So-called splitters, which are used to split or combine the signal, can generally be arranged at any distribution point.

Any electronic components, which are necessary to perform the above functions, can be contained, possibly together with a printed circuit board as a base, in a functional module, which can be called a splitter module. Similar functional modules are protection modules, which contain any components which provide protection against overvoltage and/or overcurrent, as well as testing and monitoring modules, which contain suitable electronic components and circuits in order to test and/or monitor a telecommunications line. Furthermore, other functional modules in the above sense are known to those skilled in the art.

The Applicant's EP 1 455 417 A1 describes a functional module in the field of telecommunications, which is fittable into a contact module.

DE 100 298 70 A1 discloses a module, which can be inserted into a telecommunications module and can comprise a rigid handle.

US 5,734,558 discloses a robust optoelectronic transceiver module comprising a receptacle, a transceiver housing, which can be inserted into the receptacle. Two securing levers are attached to the sides of the transceiver housing, preferable integrally molded with the transceiver housing. The securing levers are designed to accomplish a latching device which secures the transceiver housing to the receptacle housing of the receptacle. The securing levers carry detents, which engage with apertures of the receptacle housing to provide a snapping of the detents into the apertures.

US 6,449,171 discloses a handle which was cut-out from a sheet-metal like body portion. The handle is designed to be moved to a desired position, e. g. 180 ° or any other suitable position as several modular cardholders are inserted into a telecommunications chassis.

### Summary of the invention

The invention provides a functional module in the field of telecommunications, which has improved handling properties. Furthermore, a combination of a telecommunications module and a functional module with improved handling properties and an improved method of installing and/or handling a functional module are provided.

The functional module in the field of telecommunications as described herein is releasably fittable to a telecommunications module. In other words, the functional module can be brought into a positional relationship with respect to a telecommunications module, in which at least some of the contacts of both modules are connected with each other. Furthermore, there can be suitable portions on either module, which provide a mechanical connection or attachment between the modules. In particular, the functional module can be insertable into a telecommunications module. In such a case, the telecommunications module comprises a cavity or space, which is adapted to accommodate the functional module. Such an insertion of the functional module into the telecommunications module can be provided from any direction, i.e. from a front side of the telecommunications module, where contacts for connecting outside wires are exposed, as well as from a top, bottom, rear or one of the lateral sides.

In this context, reference can be made to the Applicant's above-mentioned EP 1 455 417 A1, which describes a functional module, to which the improvement described herein can be applied.

The telecommunications module, to which the functional module is fittable, can also be called a contact module as this may contain only the contacts for connecting incoming and outgoing wires therewith. Any functions, such as those described in more detail below, can be realized in the functional module.

The novel functional module comprises at least one flexible release handle attached in any suitable manner, for example on at least one side thereof. The handle, firstly, allows the functional module to be conveniently released or removed, particularly pulled out from a telecommunications module, to which it is fitted. The flexibility of the handle, secondly, provides the advantage that the handle does not interfere with any other objects, which might be present in or around a telecommunications module. For example, the telecommunications module might contain wires or cables, which are present in the surroundings of the functional module. Due to its flexibility the handle for allowing the functional module to be pulled out can be provided without interfering with such cables or wires. In particular, the handling of such cables or wires is not disturbed. Moreover, there can be situations in which two functional modules are inserted into one and the same telecommunications module from different sides thereof. In such a situation, the available space can be used very efficiently by providing at least one flexible handle in that area where the functional modules are located adjacent each other. In this manner, the functional modules can be located very close to each other and the flexible handle can, for example, be folded away requiring very little space. Thus, the available space is efficiently used.

As can be taken from the above, the flexible handle is particularly useful for removing a functional module from a telecommunications module. Furthermore, especially in the inserted state, the flexible handle leads to improved handling properties, particularly with regard to avoiding interference with other objects. However, the flexible handle can also be advantageous for any actions, which might be necessary to insert the functional module into a telecommunications module. In particular, the flexible handle can indicate an area where pressure can be applied in order to insert the functional module into a telecommunications module. Thus, the flexible handle does, firstly, not obstruct the application of pressure in any manner. For example, pressure can be applied to any side or edge of the functional module in an area where the handle is located, but folded away and/or deformed so as to allow pressure to be applied efficiently. Secondly, the flexible handle can be used to mark or denote an area where it is recommendable to apply pressure when the functional module is to be inserted. In this manner, any individual handling the functional module will be properly instructed which will help to avoid malfunctions.

A handle as described herein can be any element or object, which can be gripped, either by one or more fingers of a human being or by a tool, in order to apply a pulling force. As described in more detail below, the handle can be made of one or more pieces of tape, one or more strings or a rigid piece of material, for example made of plastic, which is connected with the functional module so as to be flexible.

For example, in the case of a rigid piece of material, the flexibility of the handle can be achieved by a pivotable connection. Moreover, the connection can be entirely loose, for example, by one or more strings or tapes, which can be formed in any suitable manner so as to provide flexibility. Generally, the fact that the handle of the novel functional module is flexible implies that the handle itself can be deformed, for example, by the resilient material properties thereof, or at least the positional relationship between the handle and the functional module can be changed. Thus, the handle can be deformed in such a way and/or be brought in such a position that it is less likely to interfere with any surrounding objects, such as cables or wires which might be present in a telecommunications module and particularly in the surroundings of a functional module inserted therein.

The handle can be formed as at least one tab. In this context, a tab describes any piece, portion or section of rigid or resilient material, which can be gripped so that it constitutes a handle.

For example, a piece of tape can be called a tab. In particular, the handle as such can be made from at least one tape. The tape can be made of flexible material so that the flexible handle of the functional module described herein can be efficiently formed without requiring many additional components and/or additional steps during manufacture. The tape may or may not have adhesive thereon as desired.

In particular, the handle can be formed by at least one tape, which is folded on and adhered to itself. Thus, at least over a part thereof, the flexible handle is made by two layers of a tape, which can be self-adhesive. Over a portion, where the tape is not adhered to itself, it can be adhered to the functional module as described in more detail below. It should additionally be mentioned that the tape can also be caused to adhere or stick by using a suitable glue or a coating, which could, for example, be activated by applying heat so as to exhibit adhering properties. Moreover, the tape itself could be made from a suitable material, such as thermoplastic material, which can be caused to stick or adhere to itself and/or the functional module by applying heat. As an alternative to the above-described measure in which a piece of tape is folded upon itself, two pieces of tape can naturally be used in the same manner. Moreover, one or more pieces of tape can be used in the flexible handle in order to attach one or more further pieces of tape to the functional module. Similarly, one or more pieces of rigid material can be attached to the functional module by one or more pieces of tape so as to provide a flexible connection which generates a flexible handle as described herein.

The handle of the functional module described herein can also be made from a substantially rigid tab which is pivotably connected with the functional module. The pivot axis can be made from a type of hinge mechanism. Moreover, the pivotable connection can be constituted by a flexible tape connecting a rigid tab with the functional module. In a further embodiment a rigid tab could be integrally formed with a part of the functional module, and the pivotal connection can be constituted by a particularly thin area which allows pulling forces to be transferred from the handle to the functional module and at the same time allows the handle to be pivoted, swiveled or turned with respect to the functional module. Such a thin section could be called a film hinge or living hinge.

It provides specific advantages when the handle comprises at least one opening. Such an opening, for example, allows a tool having a hook-type structure to be engaged with the edge of the opening so as to apply a pulling force. The same operation can be carried out by inserting one or more fingers into an opening provided in the flexible handle.

Moreover, the handle can also be formed as a loop, for which it can be said that it defines a relatively large opening within the loop into which a tool or a finger can be inserted. Thus, the pulling force can be applied to the loop in order to remove the functional module.

As regards the structure of the functional module, it can be advantageous if the functional module comprises at least one opening. Such an opening can be used to attach the flexible handle thereto. For example, one or more strings constituting at least one loop can be passed through the opening and closed to a loop. Moreover, a piece of tape can be passed through the opening and subsequently be folded upon and adhered to itself so as to constitute a flexible handle made from tape.

As regards the identification of the functional module, particularly the origin thereof, it provides advantages when the handle comprises at least one identifier formed thereon. In this way, the functional module, which can be fittable to a telecommunications module at a point in time after the installation of the telecommunications module, can be clearly identified. Furthermore, any individual handling the functional module can be provided with information regarding its authenticity and compatibility with a telecommunications module, to which the functional module is to be fitted.

The identifier can, for example, comprise at least one hologram in order have a type of proof of its origin and/or authenticity or genuineness.

It has been found advantageous when the functional module comprises handles on at least two opposing sides thereof. In this manner, particularly in a situation where two functional modules are to be fitted into one and the same telecommunications module from different sides thereof, the functional module does not have any "right" or "left" characteristic. This facilitates the handling of the novel functional module as it is not necessary to be concerned about a special type of "right" or "left" functional module to be inserted from "its" side. Rather, the functional module can be used as a "right" or "left" functional module. In particular, any flexible handles provided on both sides can be positioned adjacent each other and "meet" in the center, i.e. where the functional modules are immediately adjacent each other without interfering with each other. This is because the handles are flexible and can be deformed and/or moved in a manner suitable to allow the other handle and further objects, such as wires or cables to be accommodated in this particular area.

The functional module will usually comprise various electronic components so that it is advantageous when the functional module comprises at least one printed circuit board. In particular, the major or "carrying" component of the functional module can be constituted by a printed circuit board on which the electronic components, any contacts, which are to be connected with the contacts of a telecommunications module, as well as the one or more flexible handles described herein are attached. In particular, the printed circuit board can comprise the at least one opening as described above, to which the flexible handle can be connected.

As regards the printed circuit board, it can comprise at least one splitter circuit. In this manner, the functional module can be called a splitter module and advantageously allows ADSL-technology as described above to be used with a telecommunications module, which is equipped with such a functional module. However, the functional module can alternatively or additionally comprise protection components, such as overvoltage and/or overcurrent protectors. Furthermore, the functional module can have test and/or monitoring devices in order to test and/or monitor one or more telecommunications lines. Finally, the functional module can be intended for the transmission of a pure data signal. For this purpose, in order to be compatible with well-established telecommunications modules, any connections, such as connectors printed on the printed circuit board can be formed so as to connect the contacts of the telecommunications module with each other in a suitable manner without placing any electronic components between them. The manufacture and operation of functional modules is well known in the telecommunications field, and need not be described in any greater detail herein.

As described above, the invention provides significant advantages for a functional module, in particular the handling thereof. These advantages are also obtained if at least one functional module, as described above, is combined with at least one telecommunications module. The telecommunications module can also be called and formed as a contact module as it comprises those contacts which allow the connection of incoming and outgoing wires therewith. By the combination of at least one telecommunications module and at least one functional module the wires can be connected in a suitable manner, and any function, as detailed above, can be performed by employing a functional module transmitting and possibly processing the signal.

In the novel method of installing and/or handling a functional module, the functional module is fitted to a telecommunications module comprising at least one contact for connecting a wire therewith. At any desired point in time, the flexible release handle of the functional module can be grasped, and a pulling force can be applied to remove the functional module from the telecommunications module. One or more openings can be provided in the handle so as to allow the insertion of one or more fingers and/or a tool in order to apply the pulling force.

### Brief description of the drawings

Hereinafter, the invention will be described by several nonlimiting examples thereof with reference to the drawings, in which:
Fig. 1 shows a perspective view of a first embodiment of the functional module;
Fig. 2 shows a perspective view of a second embodiment of the functional module;
Fig. 3 shows a schematic top view of the embodiment of Fig. 2;
Fig. 4 shows a perspective view of a combination of a telecommunications module and two functional modules;
Fig. 5 shows a perspective view of a third embodiment of the functional module;
Fig. 6 shows a sectional view of the embodiment of Fig. 5 along line VI-VI; and
Fig. 7 shows a perspective view of a fourth embodiment of the functional module.

### Description of preferred embodiments of the invention

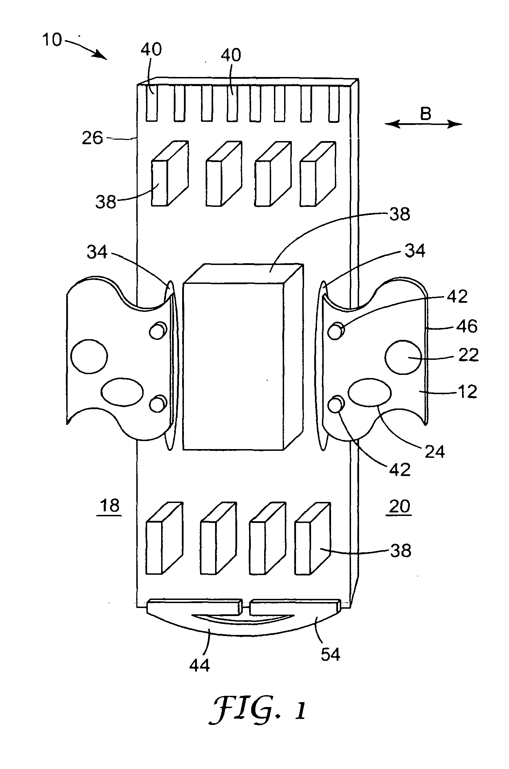

As can be taken from Fig. 1, the functional module 10 shown in the figure comprises a printed circuit board 26 as a type of carrier. In particular, electronic components 38, can be mounted to the printed circuit board 26. Furthermore, printed conductors (not shown) can be present on the printed circuit board 26, in particular on either side thereof in order to connect the electronic components 38 with each other as well as with contacts 40. The contacts 40 are formed, in the embodiment shown, adjacent an edge of the printed circuit board. In particular, the contacts 40 are adapted to contact and, therefore, be connected with contacts of a telecommunications module (not shown in Fig. 1). The embodiment shown, furthermore, comprises a grounding element 54, which is attached to the printed circuit board 26 in any suitable manner. Furthermore, the grounding element 54 is connected with printed conductors (not shown), which serve to connect appropriate contacts of the electronic components with the grounding element 54. Particularly if the electronic components 38 comprise overvoltage protectors, their ground contacts can be connected with the grounding element 54, in order to allow any overvoltage to be grounded. In the case shown, the grounding element 54 comprises a curved section 44 which provides resiliency and serves to reliably contact a portion of a metal carrier or rack in the field of telecommunications (not shown), in order to provide a reliable connection to ground.

The embodiment shown comprises a rectangular printed circuit board 26, which is not covered by any housing or cover. It should, however, be noted that such a cover or housing can be present in order to protect the functional module 10, in particular the electronic components 38 provided thereon. In the case shown, the functional module 10 is insertable into a telecommunications module (not shown) by being moved in the direction of arrow B. This insertion can be effected by applying pressure to the edge of the printed circuit board 26 on either the left 18 or right side 20 thereof.

The flexible handle 12 can be used to remove the functional module 10 from the telecommunications module by applying a pulling force to the handle 12. In the embodiment shown the handle 12 is made from a single layered piece of tape, which is attached to the printed circuit board 26 in a suitable manner, such as rivets 42 shown in Fig. 1. In the case shown, the rivets are present in a portion of the printed circuit board, which is located between an opening 34 in the form of a rounded slit, and the edge of the printed circuit board. However, in the embodiment shown in Fig. 1, the opening 34 can also be omitted, and the tape constituting the handle 12 can also be attached to any other portion of the printed circuit board 26. Furthermore, a single rivet 42 could be present. The tape 12 can also be glued to the printed circuit board 26. Finally, it is understood that the flexible handle 12 can be attached or mounted on the functional module 10 in any desired manner having sufficient strength and durability.

In the embodiment shown the handle 12 comprises an opening 22, which is in the case shown, formed approximately circular and near the outside edge 46 of the handle. The opening 22 can be used to apply the necessary pulling force for removing the functional module 10 from a telecommunications module, for example by a tool having a hook-type structure thereon, or by the finger of an individual intending to remove the functional module. Moreover, reference numeral 24 denotes an identifier, which can be present on the handle 12. For example, the identifier can be a label comprising a hologram in order to provide a type of proof of authenticity. The tape forming the handle can have any suitable shape, such as rectangular or triangular. Furthermore, any of the edges of the tape can be straight or curved. The handle 12 can be provided on any side of the functional module 10. In particular, the handle can be present on a side, which faces an inserting and/or pulling-out direction, to which the functional module is adapted.

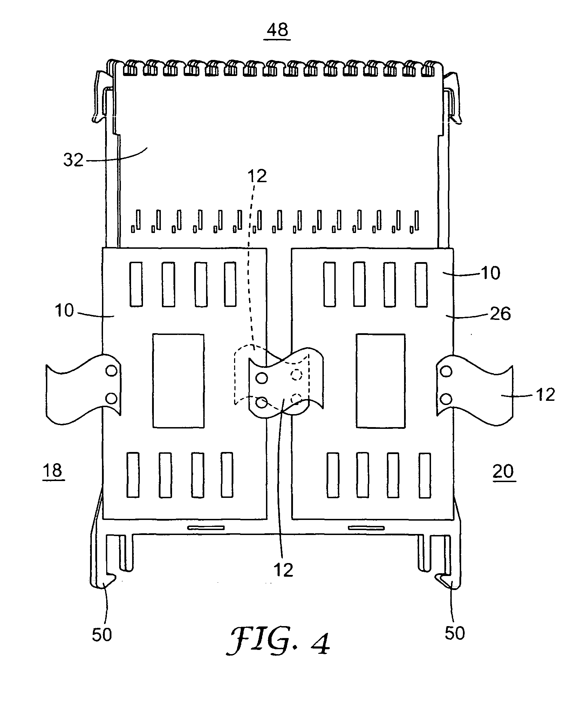

In the embodiment shown, a handle 12 is present on both the left 18 and right side 20 of the functional module 10. Thus, the functional module 10 can be called symmetrical and can be used both as a left and right side functional module, as will be described in more detail with reference to Fig. 4 below. In all further embodiments, the general structure of the functional module 10 remains the same, so that the detailed description thereof will be omitted, and the explanations will focus on the different types of flexible handles, which are provided on the further embodiments.

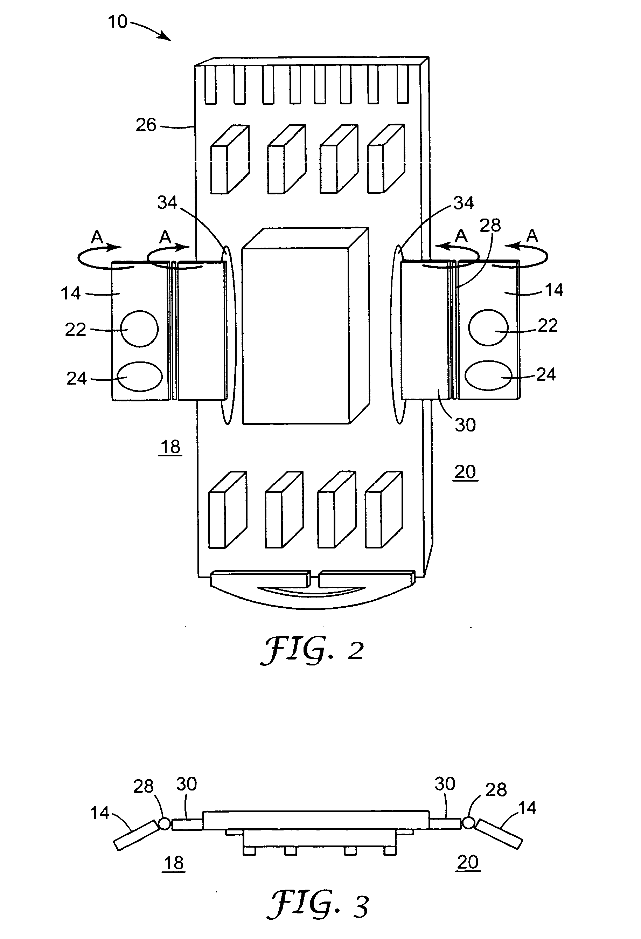

In the embodiment of Fig. 2, the flexible handle is formed by a rigid tab 14 which is, in the case shown, connected via a hinge 28 to a rigid piece of material 30. This piece of material 30 is, in any suitable manner, attached to the printed circuit board 26 so as to provide a type of "base" for the pivotable connection of the rigid tab 14 with the functional module 10. In particular, by using the hinge 28, the rigid tab 14 can be pivoted in the direction of arrow A as well as in the reverse direction so as to constitute a handle, which is flexible with respect to the functional module 10, in particular the printed circuit board 26 thereof. In the case shown, the rigid tab 14 comprises an opening 22 and an identifier 24, of which the function has been explained above with reference to Fig. 1. In a modification, which is not shown, the hinge 28 could be formed directly between the tab 14 and the printed circuit board 26, in particular at an edge thereof. Moreover, the rigid tab 14 could be flexibly connected with the functional module by one or more pieces of flexible tape.

Fig. 3 shows a schematic top view of the embodiment of Fig. 2, from which the rigid piece of material 30, the rigid tab 14 and the hinge 28 formed between them, can be seen schematically.

Fig. 4 shows a schematic view of a telecommunications module 32 and two functional modules 10 in the embodiment shown in Fig. 1. As will be apparent to those skilled in the art, the telecommunications module 32 comprises a plurality of contacts exposed at a front side 48 thereof, to which wires or cables can be connected. The telecommunications module 32 can be a disconnection module which implies that the connection between contacts of the telecommunications module can be disconnectable or separable so as to insert test plugs, protection magazines and similar objects therebetween. In the case shown, two functional modules 10 can be inserted into the telecommunications module from the left 18 and right side 20 thereof, respectively. Since the functional modules 10 are, as can additionally be taken from Fig. 1, formed symmetrical, this type of functional module can be inserted from either side. The flexible handles 12, with two handles being present in a central area of the telecommunications module, will not interfere with each other as they are flexible, so that they can be suitably deformed and/or moved, so that the two functional modules 10 can be brought into the position shown in Fig. 4, i.e. closely adjacent to each other. For example, one of the flexible handles 12 can be located at a level "behind" the printed circuit board of the second functional module, i.e. at a level further away from the viewer of Fig. 4. Fig. 4 additionally shows part of the housing of the telecommunications module, which can comprise latch hooks 50 which allow the telecommunications module to be mounted to a carrier in the field of telecommunications. Other parts of the housing are removed in order to allow the functional module 10 to be viewed. It is to be understood, however, that the telecommunications module 32 and any parts having sections such as the latch hooks 50 shown in Fig. 4 can be incorporated into a single housing. In particular, such a housing can have a cavity or space, into which the functional module 10 can be insertable.

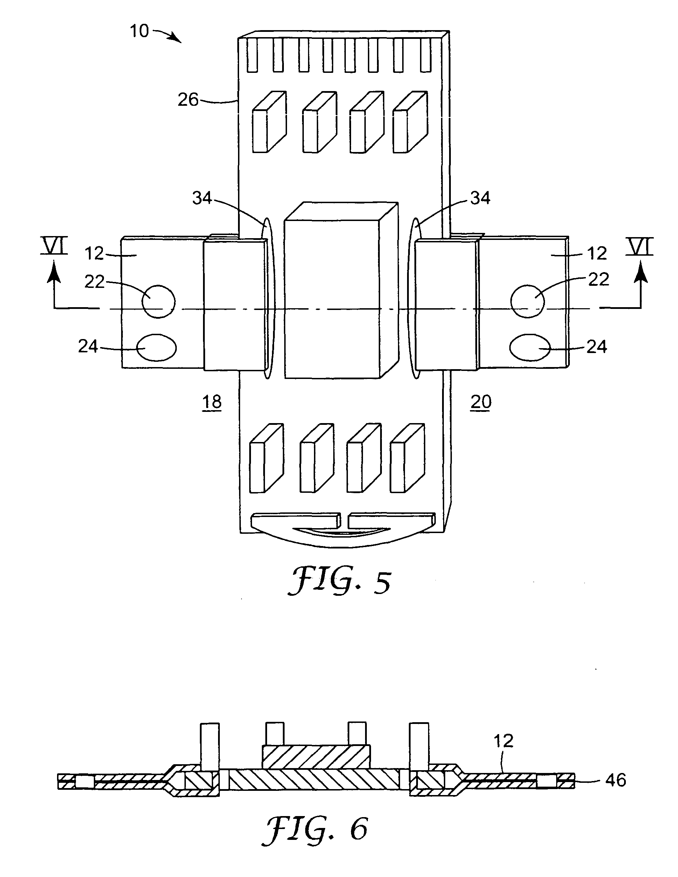

Fig. 5 schematically shows a further, third embodiment of the functional module 10, in which the handles which are present on both sides thereof, are again formed by a tape 12, which in this embodiment is an adhesive tape. However, in this case, a piece of tape has been inserted through opening 34 and has been folded upon itself. The portion of the printed circuit board 26, which is present between the opening 34 and the edge of the printed circuit board 26, is accommodated between the layers of tape and provides for the attachment of the tape. In particular, any pulling force can be applied by the handle formed by the tape 12 folded upon and adhered to itself. In the embodiment shown, the tape, which is folded in the described way, again comprises the opening 22 and the identifier 24 described above.

Fig. 6 additionally shows the double layered structure of the tape 12. It should be noted that the two layers of tape do not necessarily have to coincide at the outside edge 46 of the handle. Rather, one of the layers of the tape could be shorter than the other and could even terminate near the edge of the printed circuit board. Moreover, the tape could terminate in an area between the opening 34 of the printed circuit board 26 and the edge of the printed circuit board, as long as an attachment of the tape constituting the handle 12 is realized, which allows a pulling force to be applied.

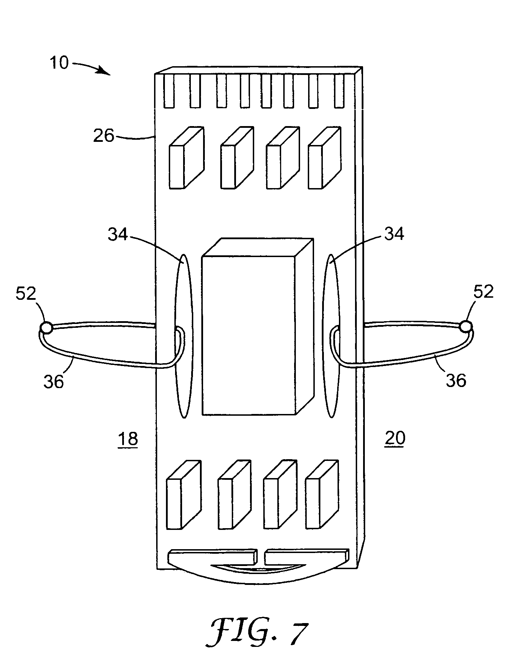

Finally, in the fourth embodiment shown in Fig. 7, a loop 36, which is inserted through opening 34, forms the flexible handle. The loop 36, which is again present on both sides of the functional module 10, is formed by a string, which is, after being inserted through opening 34, formed into a closed loop by a closure 52. Also the loop 36 as shown in Fig. 7 constitutes a flexible handle. In particular, the relatively large opening defined within the loop can be used to insert a tool or one or more fingers in order to apply the pulling force. Finally, an identifier (not shown in Fig. 7) can be attached to the loop 36 as a label.

The present invention has now been described with reference to several embodiments thereof. The foregoing detailed description and figures have been given for clarity of understanding only. No unnecessary limitations are to be understood therefrom. For example, all references to right, left, front and rear are exemplary only and do not limit the claimed invention. Moreover, any of the above-mentioned features of the functional module, in particular the flexible handle thereof, can be combined with each other. In particular, one and the same functional module can have more than one flexible handle, which can be of a different type as described above. It will be apparent to those skilled in the art that many changes can be made in the embodiments described without departing from the scope of the invention. Thus, the scope of the present invention should not be limited to the exact details and structures described herein, but rather by the structures described by the language of the claims, and the equivalents of those structures.

## Claims

1. A functional module (10) in the field of telecommunications, which is releasably fittable to a telecommunications module and comprises at least one flexible release handle (12, 14, 36) that can be deformed in such a way and/or be brought in such a position that it is less likely to interfere with any surrounding objects.

2. The functional module in accordance with claim 1, wherein the handle is formed as at least one tab (12, 14).

3. The functional module in accordance with claim 1 or 2, wherein the handle is made from at least one tape (12).

4. The functional module in accordance with claim 3, wherein the tape (12) is folded upon and adhered to itself.

5. The functional module in accordance with one of claims 2 to 4, wherein the handle is made from a substantially rigid tab (14), which is pivotally connected with the functional module (10).

6. The functional module in accordance with any of the preceding claims, wherein the handle (12, 14, 36) comprises at least one opening (22).

7. The functional module in accordance with claim 1, wherein at least one handle is formed as a loop (36).

8. The functional module in accordance with any of the preceding claims, further comprising at least one opening (34).

9. The functional module in accordance with any of the preceding claims, wherein the handle (12, 14, 36) comprises at least one identifier (24) formed thereon.

10. The functional module in accordance with claim 9, wherein the identifier comprises at least one hologram (24).

11. The functional module in accordance with any of the preceding claims, wherein handles (12, 14, 36) are provided on at least two opposing sides (18, 20) thereof.

12. The functional module in accordance with any of the preceding claims further comprising at least one printed circuit board (26).

13. The functional module in accordance with claim 12, wherein the printed circuit board (26) comprises at least one splitter circuit.

14. A combination of at least one telecommunications module and at least one functional module in accordance with any of the preceding claims.

15. A method of installing and/or handling a functional module in the field of telecommunications comprising the steps of:
- releasably fitting the functional module comprising at least one flexible release handle that can be deformed in such a way and/or be brought in such a position that it is less likely to interfere with any surrounding objects to a telecommunications module comprising at least one contact for the connection of a wire therewith,
- grasping the handle of the functional module,
- applying a pulling force to the handle to thereby remove the functional module from the telecommunications module.

16. The method of claim 15, wherein the handle comprises at least one opening through which the pulling force can be applied.

17. The method of claim 16, wherein one or more fingers and/or a tool is inserted into the opening.

## Patentansprüche

1. Funktionsmodul (10) im Gebiet der Telekommunikation, welches lösbar in ein Telekommunikationsmodul eingepasst werden kann und mindestens einen flexiblen Auslösegriff (12, 14, 36) aufweist, der so verformt und/oder in eine solche Position gebracht werden kann, dass er andere umgebende Gegenstände weniger wahrscheinlich stört.

2. Funktionsmodul nach Anspruch 1, **dadurch gekennzeichnet, dass** der Griff als mindestens eine Lasche (12, 14) gebildet ist.

3. Funktionsmodul nach Anspruch 1 oder 2, **dadurch gekennzeichnet, dass** der Griff aus mindestens einem Band (12) gefertigt ist.

4. Funktionsmodul nach Anspruch 3, **dadurch gekennzeichnet, dass** das Band (12) aufgefaltet und auf sich selbst geklebt ist.

5. Funktionsmodul nach einem der Ansprüche 2-4, **dadurch gekennzeichnet, dass** der Griff aus einer im Wesentlichen starren Lasche (14) gefertigt ist, die mit dem Funktionsmodul (10) schwenkbar verbunden ist.

6. Funktionsmodul nach einem der vorhergehenden Ansprüche, **dadurch gekennzeichnet, dass** der Griff (12, 14, 36) mindestens eine Öffnung (22) aufweist.

7. Funktionsmodul nach Anspruch 1, **dadurch gekennzeichnet, dass** mindestens ein Griff als eine Schleife (36) gebildet ist.

8. Funktionsmodul nach einem der vorhergehenden Ansprüche ferner aufweisend mindestens eine Öffnung (34).

9. Funktionsmodul nach einem der vorhergehenden Ansprüche, **dadurch gekennzeichnet, dass** der Griff (12, 14, 36) mindestens eine darauf gebildete Kennung (24) aufweist.

10. Funktionsmodul nach Anspruch 9, **dadurch gekennzeichnet, dass** die Kennung mindestens ein Hologramm (24) aufweist.

11. Funktionsmodul nach einem der vorhergehenden Ansprüche, wobei Griffe (12, 14, 36) auf mindestens zwei entgegengesetzten Seiten (18, 20) davon bereitgestellt sind.

12. Funktionsmodul nach einem der vorhergehenden Ansprüche, ferner aufweisend mindestens eine Leiterplatte (26).

13. Funktionsmodul nach Anspruch 12, **dadurch gekennzeichnet, dass** die Leiterplatte (26) mindestens eine Splitterschaltung aufweist.

14. Kombination aus mindestens einem Telekommunikationsmodul und mindestens einem Funktionsmodul nach einem der vorhergehenden Ansprüche.

15. Verfahren zum Installieren und/oder Handhaben eines Funktionsmoduls im Gebiet der Telekommunikation, aufweisend die folgenden Schritte:
- lösbares Einpassen des Funktionsmoduls, welches mindestens einen flexiblen Auslösegriff aufweist, der so verformt und/oder in eine solche Position gebracht werden kann, dass er andere umgebende Gegenstände weniger wahrscheinlich stört, in ein Telekommunikationsmodul, das mindestens einen Kontakt für die Verbindung mit einer Leitung damit aufweist,
- Greifen des Griffs des Funktionsmoduls,
- Anlegen einer Zugkraft auf den Griff, um das Funktionsmodul aus dem Telekommunikationsmodul **dadurch** zu entfernen.

16. Verfahren nach Anspruch 15, **dadurch gekennzeichnet, dass** der Griff mindestens eine Öffnung aufweist, durch die die Zugkraft angewendet werden kann.

17. Verfahren nach Anspruch 16, **dadurch gekennzeichnet, dass** ein oder mehrere Finger und/oder ein Werkzeug in die Öffnung eingeführt werden.

## Revendications

1. Module fonctionnel (10) pour le domaine des télécommunications, qui peut être relié de manière libérable à un module de télécommunications et qui comprend au moins une poignée flexible de libération (12, 14, 36) qui peut être déformée d'une façon et/ou amenée dans une position telles qu'elle est moins susceptible d'interférer avec des objets environnants quelconques.

2. Module fonctionnel selon la revendication 1, dans lequel la poignée est configurée sous la forme d'au moins une patte (12, 14).

3. Module fonctionnel selon la revendication 1 ou 2, dans lequel la poignée est constituée d'au moins un ruban (12).

4. Module fonctionnel selon la revendication 3, dans lequel le ruban (12) est replié et collé sur lui-même.

5. Module fonctionnel selon l'une des revendications 2 à 4, dans lequel la poignée est constituée d'une patte essentiellement rigide (14) reliée à pivotement au module fonctionnel (10).

6. Module fonctionnel selon l'une quelconque des revendications précédentes, dans lequel la poignée (12, 14, 36) comprend au moins une ouverture (22).

7. Module fonctionnel selon la revendication 1, dans lequel au moins une poignée est configurée en boucle (36).

8. Module fonctionnel selon l'une quelconque des revendications précédentes, qui comprend en outre au moins une ouverture (34).

9. Module fonctionnel selon l'une quelconque des revendications précédentes, dans lequel au moins un identificateur (24) est formé sur la poignée (12, 14, 36).

10. Module fonctionnel selon la revendication 9, dans lequel l'identificateur comprend au moins un hologramme (24).

11. Module fonctionnel selon l'une quelconque des revendications précédentes, dans lequel des poignées (12, 14, 36) dont prévues sur au moins deux de ses côtés opposés (18, 20).

12. Module fonctionnel selon l'une quelconque des revendications précédentes, qui comprend en outre au moins une carte de circuit imprimé (26).

13. Module fonctionnel selon la revendication 12, dans lequel la carte de circuit imprimé (26) comprend au moins un circuit diviseur.

14. Combinaison d'au moins un module de télécommunications et d'au moins un module fonctionnel selon l'une quelconques des revendications précédentes.

15. Procédé d'installation et/ou de manipulation d'un module fonctionnel pour le domaine des télécommunications, ledit procédé comprenant les étapes qui consistent à :
- installer de façon libérable sur un module de télécommunications qui comprend au moins un contact qui permet d'y relier un fil le module fonctionnel qui comprend au moins une poignée flexible de libération qui peut être déformée d'une façon et/ou amenée dans une position telles qu'elle est moins susceptible d'interférer avec des objets environnants quelconques,
- saisir la poignée du module fonctionnel et
- appliquer une force de traction sur la poignée pour ainsi retirer le module fonctionnel du module de télécommunications.

16. Procédé selon la revendication 15, dans lequel la poignée comprend au moins une ouverture par laquelle la force de traction peut être appliquée.

17. Procédé selon la revendication 16, dans lequel un ou plusieurs doigts et/ou un outil sont insérés dans l'ouverture.
